## Europäisches Patentamt

## European Patent Office

## Office européen des brevets

(19)

(11) Veröffentlichungsnummer: **0 039 020**

**A2**

(12) **EUROPÄISCHE PATENTANMELDUNG**

(21) Anmeldenummer: 81102968.5

(22) Anmeldetag: 16.04.81

(51) Int. Cl.³: **H 01 L 31/02**
H 01 L 31/18, H 01 L 21/306

(30) Priorität: 29.04.80 DE 3016498

(43) Veröffentlichungstag der Anmeldung:
04.11.81 Patentblatt 81/44

(84) Benannte Vertragsstaaten:
FR GB IT

(71) Anmelder: SIEMENS AKTIENGESELLSCHAFT Berlin
und München
Postfach 22 02 61
D-8000 München 22(DE)

(72) Erfinder: Roloff, Herbert F., Dr. rer. nat.
Akademiestrasse 21
D-8000 München 40(DE)

(54) Lichtempfindliche Halbleiterbauelemente.

(57) Zur Optimierung des Wirkungsgrades lichtempfindlicher Halbleiterbauelemente wird bei der Herstellung eine anisotrope Ätzung mittels Masken auf einer Halbleiteroberfläche von bestimmter Kristallorientierung so durchgeführt, daß ein vorbestimmtes Muster erzeugt wird und daß die Kristallorientierung der Halbleiteroberfläche sowie das vorbestimmte Muster auf der Halbleiteroberfläche und die Lage der fotoaktiven p-n-Übergänge der Halbleiterbauelemente so bestimmt werden, daß der Wirkungsgrad der lichtempfindlichen Halbleiterbauelemente maximal erhöht wird.

Anwendung bei Fotodioden, Fototransistoren und bei integrierten Schaltungen mit lichtempfindlichen Bauelementen.

FIG 2

SIEMENS AKTIENGESELLSCHAFT
Berlin und München

Unser Zeichen
VPA

80 P 1 0 6 1 E

Lichtempfindliche Halbleiterbauelemente.

Die Erfindung betrifft lichtempfindliche Halbleiterbauelemente wie Fotodioden oder Fototransistoren, deren optische Strahlung aufnehmende Halbleiteroberfläche durch
anisotrope Ätzungen von Halbleiterkristallen uneben geformt ist.

Aus DE-OS·16 21 511 ist eine anisotrope Oberflächenätzung
von (1 0 0)-Siliciumoberflächen in der Weise bekannt, daß
dadurch mehr oder minder unregelmäßig verformte Halbleiteroberflächen entstehen, die den Vorteil haben, bei
Mehrfachreflexionen als Lichtfalle zu wirken und dadurch
den Wirkungsgrad von danach gefertigten lichtempfindlichen Halbleiterbauelementen zu erhöhen. Bei einer solchen
anisotropen Ätzung von Halbleiteroberflächen, z.B. der
1 0 0-Siliciumoberfläche werden die Halbleiteroberflächen
statistisch verformt. Um den Wirkungsgrad von lichtempfindlichen Halbleiterbauelementen zu optimieren, muß hingegen eine Halbleiteroberflächenätzung nach einem vorbestimmten
Muster erfolgen, das seinerseits wiederum mit der Lage
der im Halbleiterkörper enthaltenen fotoaktiven p-n-Übergänge abgestimmt sein muß.

Aufgabe der Erfindung ist es daher, lichtempfindliche
Halbleiterbauelemente mit optimiertem Wirkungsgrad anzugeben, wobei bei der Optimierung die Kristallorientierung
der Halbleiteroberfläche sowie Ätzmuster und Lage der optisch aktiven p-n-Übergänge im Halbleiterbauelement berücksichtigt werden.

Diese Aufgabe wird bei einer anisotropen Ätzung der Halbleiteroberfläche dadurch erreicht, daß die Ätzung mittels Masken
auf einer Halbleiteroberfläche von bestimmter Kristallorientierung ein vorbestimmtes Muster erzeugt und daß die Kristallorientierung der Halbleiteroberfläche sowie das vorbestimmte Muster auf der Halbleiteroberfläche und die Lage der fotoaktiven p-n-Übergänge der Halbleiterbauelemente so bestimmt werden, daß der Wirkungsgrad der lichtempfindlichen Halbleiterbauelemente maximal erhöht wird.

Es ist vorteilhaft, daß das Halbleitermaterial Silicium ist. Da für die Herstellung von Halbleiterbauelementen und integrierten Schaltungen mittels Silicium zahlreiche bekannte und erprobte Verarbeitungstechnologien vorliegen, ist es vorteilhaft und kostensparend, als Halbleitermaterial Silicium zu verwenden.

Weiterhin ist es erfinderisch, daß die Halbleiteroberfläche mittels Masken so geätzt wird, daß durch die Ätzung Gräben von V-förmigem Querschnitt entstehen. V-förmige Gräben auf Halbleiteroberflächen bewirken, daß das auftreffende Licht auf die Flankenflächen der Gräben nicht senkrecht, sondern unter einem gewissen Winkel auffällt.

Die Erzeugung von V-förmigen Gräben auf lichtempfindlichen Halbleiteroberflächen hat den Vorteil, eine schräge Durchstrahlungsrichtung für einen oder mehrere p-n-Übergänge und benachbarte Verarmungsschichten herzustellen. Dadurch wird der Lichtweg und damit auch die Lichtausbeute entsprechend vergrößert gegenüber einem Lichtstrahl, der die Verarmungsschichten und den p-n-Übergang senkrecht durchsetzt. Insbesondere bei infrarotem Licht bringt diese Maßnahme wegen entsprechender Absorptionsbedingungen einen erheblichen Vorteil.

Es ist vorteilhaft, daß die mittels Masken zu ätzende Halbleiteroberfläche eine Siliciumoberfläche mit (1 0 0-) Kristallorientierung ist. Mittels dieser Kristallorientierung der Siliciumoberfläche lassen sich Gräben von günstigem Flankenwinkel, nämlich mit einem Winkel von

54,74° zwischen Grabenflanke und der (1 0 0-)Kristallorientierung der Siliciumoberfläche erreichen. Es wird dadurch eine möglichst hohe Lichtausbeute im Kristall für annähernd senkrecht auf die (1 0 0-)Kristallorientierungsebene einfallendes Licht bewirkt.

Für verschiedene Anwendungsbeispiele ist es vorteilhaft, daß die Maske auf der Halbleiteroberfläche so angebracht ist, daß die durch die Ätzung entstehenden Gräben parallel zueinander verlaufen. Anwendungsbeispiele von lichtempfindlichen Halbleiterbauelementen oder integrierten Schaltungen können an ihrer Oberfläche ein Raster von parallel zueinander verlaufenden eingeätzten Gräben aufweisen. Es ist jedoch auch möglich, ein weiteres, das erste Raster von parallel zueinander verlaufenden Gräben überkreuzendes Raster von parallel zueinander verlaufenden Gräben auf entsprechenden lichtempfindlichen Oberflächen anzubringen.

Es ist weiterhin vorteilhaft, daß die zwischen zwei benachbarten Gräben verbleibenden Stegflächen der ursprünglichen Halbleiteroberfläche möglichst klein sind. Wenn die zwischen benachbarten Gräben verlaufenden Stegflächen der ursprünglichen Halbleiteroberfläche möglichst gering gehalten werden und damit der über die Stegflächen einfallende Lichtanteil entsprechend gering ist, so ist die Gesamtlichtausbeute aus den oben genannten Gründen entsprechend groß.

Es ist auch vorteilhaft, daß die durch Ätzung entstandenen Halbleiteroberflächenteile mittels einer optischen Vergütungsschicht so versehen werden, daß von außen einfallende elektromagnetische Strahlung die Vergütungsschicht durchdringen und in den Halbleiterkörper gelangen kann, während reflektierte Strahlung aus dem Halbleiterinneren mittels Totalreflexion an einer der Grenzflächen der Vergütungsschicht am Verlassen des Halbleiterkristalls

gehindert wird, und daß die optische Vergütungsschicht aus zwei oder mehreren Schichten der Stoffe Siliciumdioxid, Siliciumnitrid, Titanoxid besteht. Eine Vergütung der Flankenflächen der in den Kristall eingebrachten Gräben bewirkt eine Reflexionsverminderung und, daß ein höherer Anteil von zurückgeworfenem Licht im Halbleiterkristall verbleibt. Es ist wichtig, daß auf den Flankenflächen der eingebrachten Gräben erfindungsgemäße Vergütungsschichten angebracht werden. Die Stegflächen der ursprünglichen Halbleiteroberfläche können zwar auch mit Vergütungsschichten versehen sein. Diese Maßnahme ist jedoch für die Stegflächen nicht zwingend.

Es ist auch erfinderisch, daß nach erfolgten Diffusionsprozessen auf der die optische Strahlung aufnehmenden Halbleiteroberfläche mittels Maskierung und Fotolithografie die zu ätzenden Halbleiteroberflächenteile freigelegt werden und anschließend mittels einer Ätzflüssigkeit wie z.B. KoH oder Brenzkatechin in an sich bekannter Weise (vgl. IEEE Transactions on Electron Devices, Vol. ED-25, No. 10 October 1978, Seiten 1185-1193) Vertiefungen in die Halbleiteroberfläche eingeätzt werden. Dieses Verfahren hat den Vorteil, daß es sowohl auf entsprechende Halbleiterbauelementen wie auch auf integrierten Schaltungen oder Teilen von integrierten Schaltungen angebracht werden kann.

Nachfolgend wird die Erfindung an einem Ausführungsbeispiel und der Zeichnung näher erläutert. Es zeigen

Fig. 1 einen Ausschnitt eines lichtempfindlichen Halbleiterbauelements mit Ätzmaske, dargestellt im Querschnitt,

Fig. 2 einen Ausschnitt eines lichtempfindlichen Siliciumhalbleiterbauelements im Querschnitt und nach erfolgter Oberflächenätzung,

Fig. 3 einen Ausschnitt eines lichtempfindlichen Siliciumhalbleiterbauelments im Querschnitt, nach erfolgter Ätzung und Oberflächenvergütung.

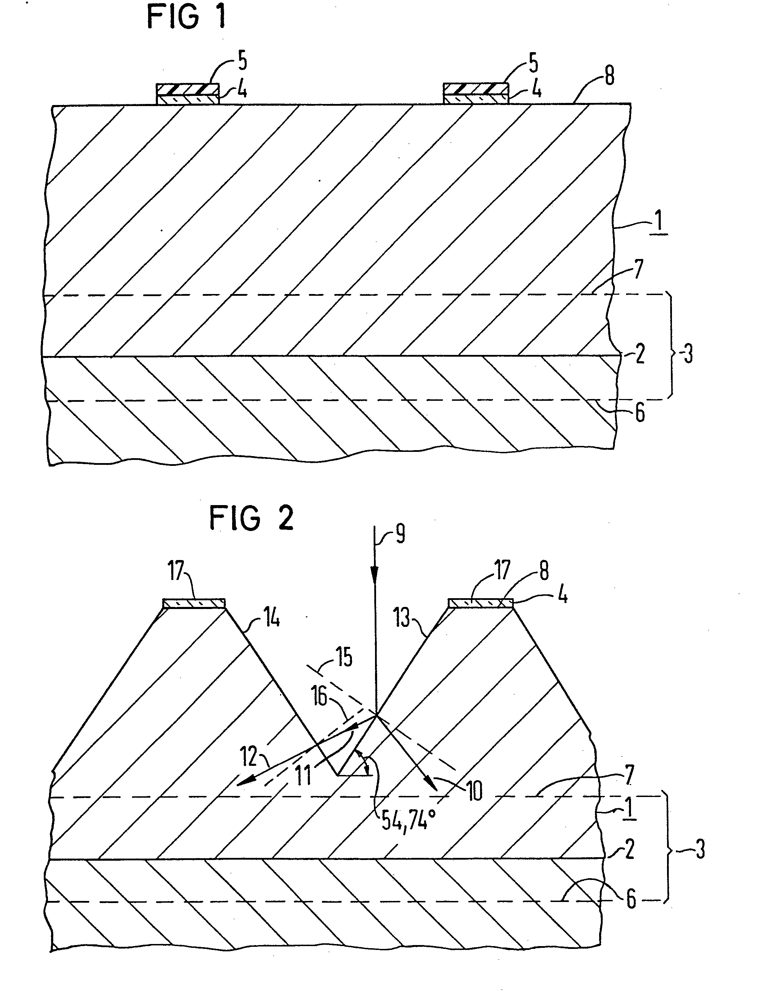

Fig. 1 stellt im Querschnitt einen Ausschnitt aus einem lichtempfindlichen Halbleiterkörper 1 dar. Der lichtempfindliche Halbleiterkörper 1 kann mehrere Halbleiterbauelemente enthalten, z.B. Fotodioden oder Fototransistoren oder auch integrierte Schaltungen. Zur Vereinfachung der Darstellung wurde lediglich ein lichtempfindlicher p-n-Übergang 2 in den Figuren dargestellt. Der p-n-Übergang 2 wird von einer Verarmungsschicht 3, dargestellt durch die strichlierten Linien 6 und 7, umgeben. Auf der Halbleiteroberfläche 8 ist eine Ätzmaske, bestehend aus einer Schicht 4 und einer Fotomaske 5, aufgebracht. Die Schicht 4 kann beispielsweise aus Siliciumoxid oder Siliciumnitrid oder aus diesen beiden Stoffen bestehen. Zur Erzeugung der Ätzmaske auf der Halbleiteroberfläche 8 wird zunächst die Schicht 4 ganzflächig hergestellt. Danach wird ganzflächig Fotolack aufgebracht. Durch Belichten und anschließendes Ablösen der nicht belichteten Fotolackteile entsteht zunächst die Fotomaske 5. Ein weiterer Ätzschritt entfernt die verbliebenen und von der Fotomaske 5 nicht abgedeckten Teile der Schicht 4. Ein nachfolgendes Ätzen der Halbleiteroberfläche 8 z.B. einer (1 0 0-) Siliciumoberfläche mittels z.B. KoH oder Brenzkatechin erzeugt in einer Siliciumoberfläche der Kristallorientierung (1 0 0) V-förmige Gräben.

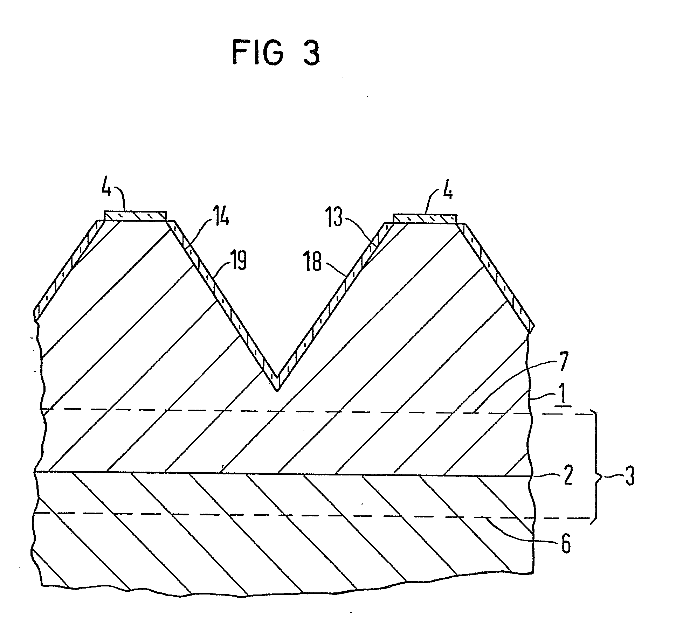

In Fig. 2 sind die durch Ätzung einer (1 0 0-)Siliciumoberfläche erzeugten Gräben dargestellt. Gleiche Teile von Fig. 1 sind mit gleichen Bezugszeichen belegt und werden in Fig. 2 sowie in Fig. 3 nicht mehr eigens beschrieben. Pfeil 9 deutet die Richtung der auf den lichtempfindlichen Halbleiterkörper 1 einfallenden Strahlung an. Ein in Richtung des Pfeils 9 auf die Flanke 13 auffallendes Lichtbündel wird gemäß Pfeil 10 zum Lot 15 hin gebrochen. Das gebrochene Lichtbündel durchsetzt in Richtung Pfeil 10 die Verarmungsschicht 3 und den p-n-Übergang 2 schräg, so daß der Lichtweg und damit die Lichtausbeute größer ist als das für ein entsprechendes Lichtbündel bei senkrechtem Durchlaufen der Verarmungsschicht3 sowie des p-n-Übergangs 2 der Fall ist. Insbesondere bei infrarotem Licht führt ein solcher schräger Lichteinfall zu einem höheren Fotostrom bei sonst gleichen Halbleiterbauelementen. Auch der an der Flanke 13 reflektierte Anteil, der in Richtung des Pfeils 11 auf die Flanke 14 trifft, dort zum Lot 16 hin gebrochen wird und in Richtung des Pfeils 12 die Verarmungsschicht 3 und den p-n-Übergang 2 durchsetzt, weist durch seinen schrägen Verlauf einen größeren Lichtweg durch die fotoaktive Zone auf, wodurch ebenfalls der Fotostrom bzw. der Wirkungsgrad eines solchen Bauelements heraufgesetzt wird.

Wird die Halbleiteroberfläche 8 als Siliciumfläche paral-lel zur (1 0 0-)Ebene gewählt, so ergeben sich durch Ätzung die in Fig. 2 dargestellten Gräben mit den Flanken 13 und 14, wobei der Winkel zwischen einer Flanke 13 bzw. 14 einerseits und der (1 0 0-)Ebene andererseits 54,74° beträgt. Die von der Maskierung abgedeckten verbleibenden Stege 17 der ursprünglichen Halbleiteroberfläche 8 sind je nach Technologie so klein wie möglich zu halten, um den über diese Stege 17 einfallenden Strahlungsanteil, der von geringerem Wirkungsgrad ist als der über die Flanken 13 und 14 einfallende Strahlungsanteil, möglichst gering zu halten. Die in Fig. 2 dargestellten Flanken 13 und 14 können zu einem regelmäßigen Netz von parallelen Gräben mit V-förmigem Querschnitt über die lichtempfindliche Halbleiteroberfläche ausgebildet sein. Diese Gräben können aber auch durch weitere quer zu den ersten Gräben verlaufende zweite Gräben gekreuzt werden.

Die in Fig. 2 beschriebene Strukturierung von Halbleiteroberflächen kann sowohl bei Einzelhalbleiterbauelementen wie lichtempfindlichen Dioden oder lichtempfindlichen Transistoren angebracht werden. Sie kann aber auch auf Halbleiteroberflächen oder Halbleiteroberflächenteilen einer integrierten Schaltung angebracht werden, die lichtempfindliche Bauelemente wie lichtempfindliche Dioden oder lichtempfindliche Transistoren enthält.

Fig. 3 stellt ein erfindungsgemäßes lichtempfindliches Halbleiterbauelement wie in Fig. 2 dar, das zusätzlich an der Flanke 13 eine Schicht 18 und an der Flanke 14 eine Schicht 19 enthält. Die Schichten 18 und 19 können Passivierungsschichten sein, deren Dicke auf dem Kristall so gewählt ist, daß für die eingestrahlte Lichtwellenlänge infolge der Interferenz in der Passivierungsschicht eine minimale Reflexion auftritt. Die Schichten 18 oder 19 können aber auch eine solche Passivierungsschicht oder eine zweite auf ihr abgeschiedene Schicht mit einem solchen Brechungsindex darstellen, daß an einer der Grenzflächen Totalreflexion eintritt, so daß das einfallende Licht zwar in den Halbleiter gelangen, aber diesen nicht verlassen kann. Die Schichten 18 und 19 können z.B. aus Siliciumoxid, Siliciumnitrid oder aus Titanoxid bestehen oder sie können eine Schichtenfolge der genannten Materialien darstellen. Die Schicht 4 kann aus Siliciumdioxid bestehen, sie kann aber auch die gleiche Zusammensetzung wie die Schichten 18 und 19 aufweisen.

Zur Herstellung von erfindungsgemäßen lichtempfindlichen Halbleiterbauelementen wie Fotodioden oder Fototransistoren oder integrierten Schaltungen mit lichtempfindlichen Halbleiterbauelementen werden nach Abschluß der Diffusionsprozesse, die z.B. für die Herstellung von p-n-Übergängen notwendig sind, mittels Maskierung und Fotolithographie die zu ätzenden Flächen definiert. Danach werden V-förmige Gräben durch ein geeignetes Ätzmittel wie z.B. KoH oder Brenzkatechin erzeugt. Als Abstand zwischen den Gräben wird der minimale Abstand gewählt, den der zugehörige fotolithographische Prozess zuläßt.

Nach der Ätzung wird die Siliciumoberfläche mit einer Passivierungsschicht, insbesondere aus Mehrfachschichten bestehend, versehen, die entweder bezüglich Material und Schichtdicke so beschaffen ist, daß an mindestens einer ihrer Grenzflächen Totalreflexion für die Wellenlänge des verwendeten Lichtes erfolgt und in einer oder mehreren Schichten durch Interferenz eine Reflexionsverminderung eintritt.

9 Patentansprüche
3 Figuren

Patentansprüche

1. Lichtempfindliche Halbleiterbauelemente wie Fotodioden oder Fototransistoren, deren optische Strahlung aufnehmende Halbleiteroberfläche durch anisotrope Ätzungen von Halbleiterkristallen uneben geformt ist, d a d u r c h g e k e n n z e i c h n e t, daß die Ätzung mittels Masken auf einer Halbleiteroberfläche von bestimmter Kristallorientierung ein vorbestimmtes Muster erzeugt und daß die Kristallorientierung der Halbleiteroberfläche sowie das vorbestimmte Muster auf der Halbleiteroberfläche und die Lage der fotoaktiven p-n-Übergänge der Halbleiterbauelemente so bestimmt werden, daß der Wirkungsgrad der lichtempfindlichen Halbleiterbauelemente maximal erhöht wird.

2. Lichtempfindliche Halbleiterbauelemente nach Anspruch 1, d a d u r c h g e k e n n z e i c h n e t, daß das Halbleitermaterial Silicium ist.

3. Lichtempfindliche Halbleiterbauelemente nach den Ansprüchen 1 oder 2, d a d u r c h g e k e n n z e i c h n e t, daß die Halbleiteroberfläche mittels Masken so geätzt wird, daß durch die Ätzung Gräben von V-förmigem Querschnitt entstehen.

4. Lichtempfindliche Halbleiterbauelemente nach den Ansprüchen 2 und/oder 3, d a d u r c h g e k e n n - z e i c h n e t, daß die mittels Masken zu ätzende Halbleiteroberfläche eine Siliciumoberfläche mit (1 0 0-) Kristallorientierung ist.

5. Lichtempfindliche Halbleiterbauelemente nach Anspruch 3, d a d u r c h g e k e n n z e i c h n e t, daß die Maske auf der Halbleiteroberfläche so angebracht ist, daß die durch die Ätzung entstehenden Gräben parallel zueinander verlaufen.

6. Lichtempfindliche Halbleiterbauelemente nach einem der Ansprüche 4 und/oder 5, d a d u r c h   g e k e n n -
z e i c h n e t,   daß die zwischen zwei benachbarten Gräben verbleibenden Stegflächen der ursprünglichen Halbleiteroberfläche möglichst klein sind.

7. Lichtempfindliche Halbleiterbauelemente nach mindestens einem der Ansprüche 1 bis 6,   d a d u r c h   g e -
k e n n z e i c h n e t,   daß die durch Ätzung entstandenen Halbleiteroberflächenteile mittels einer optischen Vergütungsschicht so versehen werden, daß von außen einfallende elektromagnetische Strahlung die Vergütungsschicht durchdringen und in den Halbleiterkörper gelangen kann, während reflektierte Strahlung aus dem Halbleiterinneren mittels Totalreflexion an einer der Grenzflächen der Vergütungsschicht am Verlassen des Halbleiterkristalls gehindert wird.

8. Lichtempfindliche Halbleiterbauelemente nach Anspruch 7, d a d u r c h   g e k e n n z e i c h n e t,   daß die optische Vergütungsschicht aus zwei oder mehreren Schichten der Stoffe Siliciumdioxid, Siliciumnitrid, Titanoxid besteht.

9. Verfahren zur Herstellung von lichtempfindlichen Halbleiterbauelementen nach einem der Ansprüche 1 bis 6, d a -
d u r c h   g e k e n n z e i c h n e t,   daß nach erfolgten Diffusionsprozessen auf der die optische Strahlung aufnehmenden Halbleiteroberfläche mittels Maskierung und Fotolithographie die zu ätzenden Halbleiteroberflächenteile freigelegt werden und anschließend mittels einer Ätzflüssigkeit wie z.B. Brenzkatechin in an sich bekannter Weise, Vertiefungen in die Halbleiteroberfläche eingeätzt werden.

FIG 1

FIG 2

54,74°

0039020

FIG 3